# FASCICULE DE BREVET EUROPEEN

(11) **EP 0 840 373 B1**
(45) Date de publication et mention de la délivrance du brevet: **07.05.2003**
(21) Numéro de dépôt: 97402536.3
(22) Date de dépôt: 27.10.1997
(51) Int. Cl.: H01L 23/373, C04B 37/02

(54) **Procèdè de liaison d'un substrat de diamant à au moins un substrat métallique**
Verfahren zum Verbinden von einem Diamantsubstrat mit mindestens einem metallischen Substrat
Process for bonding a diamon substrate to at least one metallic substrate

(30) Priorité: 31.10.1996 FR 9613321
(43) Date de publication de la demande: 06.05.1998
(73) Titulaire: ALCATEL, 75008 Paris (FR)
(72) Inventeur: Petitbon, Alain, 78730 Saint-Arnoult (FR); Ranchy, Eric, 92140 Clamart (FR)
(74) Mandataire: Sciaux, Edmond

(56) Documents cités:
- EP-A- 0 717 125
- US-A- 3 922 775
- US-A- 5 423 475
- FIEGL B ET AL: "DIAMOND FILMS AS THERMAL CONDUCTORS AND ELECTRICAL INSULATORS APPLIED TO SEMICONDUCTOR POWER MODULES" DIAMOND AND RELATED MATERIALS, vol. 3, no. 4/06, 1 avril 1994, pages 658-662, XP000466679
- "Properties and growth of diamond (EMIS Datareviews Series n 9)" 1994 , INSPEC PUBLICATION, EDITED BY GORDON DAVIES , LONDON, GB XP002034103 * page 312 *

## Description

Dans les modules électroniques de puissance, il est nécessaire de refroidir les composants électroniques de puissance ayant des potentiels importants.

Un moyen de refroidissement classique comprend le brasage du composant sur une piste de cuivre, elle même montée sur une céramique isolante électriquement de type AlN ou équivalent, destinée à isoler le composant et la piste de cuivre à haut potentiel de la semelle et dispositif de refroidissement mis à la masse.

La structure multicouche piste de cuivre/ AlN est bien adaptée à l'isolation électrique du composant de puissance, cependant les nombreuses interfaces, brasures, colles et graisses utiliser pour fabriquer cette structure multicouche constituent une résistance thermique cumulée importante (de l'ordre de 15 10⁻⁶ K/W pour 625 µm d'AlN et 300µm de Cu) affectant les capacités de la structure à évacuer convenablement les pertes joules issues des composants de puissance, par elle même, ou par l'intermédiaire d'un dispositif de refroidissement.

En outre plus on augmente le potentiel, plus la couche de céramique diélectrique doit être importante, or il est connu que les diélectriques céramiques ne sont pas bon conducteur de chaleur.

On connaît l'utilisation de diamant artificiel présentant l'avantage d'être un excellent isolant électrique et d'avoir une conductivité thermique de l'ordre de 10 fois supérieure à l'AlN (diamant : 1500 W/m.K ; AlN : 180 W/m.K).

Le soudage d'un substrat de diamant artificiel sur une piste en cuivre ou en aluminium comprend en général
une première étape de métallisation par technique PVD durant laquelle on dépose une fine couche de titane, de platine et d'or sur le substrat en diamant artificiel;
une seconde étape de brasage dans laquelle on brase, selon les procédés de brasage classique, le substrat composite diamant/Ti,Pl,Au sur la piste en cuivre ou en aluminium.

Le gain de dissipation thermique est de l'ordre de 25 à 30 % par rapport au multicouche AlN.

Ce gain est peu élevé au regard de ce que les caractéristiques de conducteur thermique du diamant artificiel peuvent laisser espéré.

Cela est dû au brasage qui crée une résistance thermique importante (résistance thermique cumulée de l'ordre de 13 10⁻⁶ K/W pour 300 µm de diamant, 100µm brasure, et 300µm de Cu, dont 12 10⁻⁶ induit par la brasure et les interfaces).

En outre, le coût d'achat très élevé du diamant artificiel, rend le rapport coût de production sur gain de dissipation thermique très supérieur à la technique AlN et donc rédhibitoire pour une utilisation en série.

Par ailleurs, le document **EP-A6 0.717.125** décrit un procédé de liaison d'un substrat de diamant à au moins un substrat métallique, comprenant les étapes suivantes :
- recouvrir au moins une face du substrat de diamant par une couche d'un métal (aluminium) ;
- disposer ledit substrat de diamant recouvert sur un substrat métallique, la surface recouverte de métal étant au contact du substrat métallique ;
- puis lier par thermocompression ledit substrat de diamant recouvert et ledit substrat métallique.

Un des but de la présente invention est de proposer un procédé pour réaliser une liaison entre un substrat métallique et un substrat de diamant avec des interfaces ayant des résistances thermiques réduites.

A cet effet l'invention concerne un procédé pour lier un substrat de diamant à au moins un substrat métallique. Selon les étapes du procédé de l'invention,
au moins une face du substrat de diamant recouverte par une feuille d'aluminium;
ledit substrat de diamant et ladite feuille d'aluminium sont disposés dans une enceinte à atmosphère contrôlée et sont liés ensemble par une première étape de thermo-compression sous Argon ou sous vide, réalisant ainsi un substrat multicouche composite;
ledit substrat multicouche composite est disposé sur un substrat métallique, la surface en aluminium au contact du substrat métallique;
et ledit substrat multicouche composite et ledit substrat métallique sont liés par une deuxième étape de thermo-compression.

Dans une variante de réalisation, ledit substrat multicouche composite comprend ledit substrat de diamant pris en sandwich entre deux feuilles d'aluminium, et des substrats métalliques sont liés à chacune des feuilles d'aluminium.

Dans un mode de mise en oeuvre de la première étape de thermo-compression du procédé selon l'invention, la température de thermo-compression est comprise entre 550°C et 650°C, et la pression appliquée pour la thermo-compression est comprise entre 100 et 150 kg/cm².

Dans le cas où le substrat métallique est un substrat en cuivre, la température de la seconde thermo-compression est comprise entre 500°C et 550°C, et la pression appliquée pour la seconde thermo-compression est comprise entre 100 et 150 kg/cm².

D'autres avantages et caractéristiques de la présente invention résulteront de la description qui va suivre.

La thermo-compression diminue sensiblement les résistances thermiques des interface entre les différents matériaux.

Cependant pour thermo-comprimer du cuivre directement sur un substrat de type diamant, les températures mises en jeu sont de l'ordre de 1000 °C or il est connu que le diamant CVD n'est pas stable au-delà de 800 à 900 °C et se transforme en graphite.

Pour pallier cet inconvénient rédhibitoire, le procédé pour lier un substrat de diamant à au moins un substrat métallique selon l'invention repose sur deux étapes de thermo-compression.

La première étape de thermo-compression met en jeu le substrat de diamant et au moins une feuille d'aluminium.

Une des faces du substrat de diamant est recouverte par une feuille d'aluminium;
l'ensemble substrat de diamant / feuille d'aluminium est disposés dans une enceinte de thermo-compresseur à atmosphère contrôlée;
la première étape de thermo-compression se fait sous Argon ou sous vide et permet de lier ensemble la feuille d'aluminium avec le substrat de diamant, réalisant ainsi un substrat multicouche composite. Dans une variante de réalisation, le substrat de diamant est pris en sandwich entre deux feuilles d'aluminium. Les températures mise en jeu pour la thermo-compression sont de l'ordre de 600°C, températures auxquelles le diamant CVD est parfaitement stable.
le substrat multicouche composite réalisé dans la première étape de thermo-compression est disposé sur un (ou des) substrat(s) métallique(s), la (les) surface(s) en aluminium au contact du (des) substrat(s) métallique(s); et
une seconde étape de thermo-compression permet de lier la (les) face(s) aluminium avec le (les) substrat(s) métallique(s). La aussi, les température de thermo-compression mises en jeu sont de l'ordre de 600°C.

Dans un mode de mise en oeuvre de la première étape de thermo-compression du procédé selon l'invention, la température de thermo-compression est comprise entre 550°C et 650°C, et la pression appliquée pour la thermo-compression est comprise entre 100 et 150 kg/cm².

Dans le cas où le substrat métallique est un substrat en cuivre, la température de la seconde thermo-compression est comprise entre 500°C et 550°C, et la pression appliquée pour la seconde thermo-compression est comprise entre 100 et 150 kg/cm².

Dans une réalisation illustrative, mais non limitative, de l'invention, il a été réalisé une liaison entre un substrat de 300 µm de diamant, une feuille de 100 µm d'aluminium, et un substrat de cuivre de 300 µm. La résistance thermique cumulée est de 2,9 10⁻⁶ soit 5 fois moins que dans les techniques antérieures.

De nombreux avantages découlent directement de cette diminution de la résistance thermique :
d'une part, cela rend l'utilisation de diamant compétitif même si son coût d'achat est de l'ordre de 10 fois celui de l'AlN.

D'autre part, cela permet de diminuer l'encombrement des modules d'électronique de puissance en diminuant les épaisseurs d'isolant et en réduisant les tailles des dispositifs d'évacuation de la chaleur.

Enfin, pour des dimensions équivalentes, cela permet de faire passer dans les modules d'électronique des puissances plus importantes.

Bien entendu, l'invention n'est pas limitée au mode de mise en oeuvre ou de réalisation décrit, mais elle est susceptible de nombreuses variantes accessibles à l'homme du métier sans que l'on s'écarte de l'invention. En particulier, le substrat métallique peut être autre que le cuivre, de même la feuille d'aluminium peut être remplacée par tout matériau qui permet d'obtenir une liaison par thermo-compression, avec les substrats de diamant et métalliques, à des températures inférieures aux températures de transformation du diamant.

## Revendications

1. Procédé de liaison d'un substrat de diamant à au moins un substrat métallique **caractérisé en ce que** :
au moins une face du substrat de diamant est recouverte par une feuille d'aluminium;
ledit substrat de diamant et ladite feuille d'aluminium sont disposés dans une enceinte à atmosphère contrôlée et sont liés ensemble par une première étape de thermo-compression sous Argon ou sous vide, réalisant ainsi un substrat multicouche composite;
ledit substrat multicouche composite est disposé sur un substrat métallique, la surface en aluminium au contact du substrat métallique; et
ledit substrat multicouche composite et ledit substrat métallique sont liés par une deuxième étape de thermo-compression.

2. Procédé selon la revendication 1 **caractérisé en ce que** ledit substrat de diamant est pris en sandwich entre deux feuilles d'aluminium.

3. Procédé selon la revendication 1 ou 2 **caractérisé en ce que** dans la première étape de thermo-compression, la température de thermo-compression est comprise entre 550°C et 650°C, et la pression appliquée pour la thermo-compression est comprise entre 100 et 150 kg/cm².

4. Procédé selon l'une quelconque des revendications 1 à 3 **caractérisé en ce que** le substrat métallique est un substrat en cuivre.

5. Procédé selon la revendication 4 **caractérisé en ce que**, la température de la seconde thermo-compression est comprise entre 500°C et 550°C, et la pression appliquée pour la seconde thermo-compression est comprise entre 100 et 150 kg/cm².

## Claims

1. A method of bonding a diamond substrate to at least one metal substrate, the method being **characterized in that**:
at least one of the faces of the diamond substrate is covered with a piece of aluminum foil;
said diamond substrate and said piece of aluminum foil are disposed in a chamber under a controlled atmosphere, and they are bonded together by a first thermocompression step under Argon or under a vacuum, thereby forming a composite multilayer substrate;
said composite multilayer substrate is disposed on a metal substrate, the aluminum surface being in contact with the metal substrate; and
said composite multilayer substrate and said metal substrate are bonded together by performing a second thermocompression step.

2. A method according to claim 1, **characterized in that** said diamond substrate is sandwiched between two pieces of aluminum foil.

3. A method according to claim 1 or 2, **characterized in that**, in the first thermocompression step, the thermocompression temperature lies in the range 550°C to 650°C, and the pressure applied for performing the thermo-compression lies in the range 100 kilograms per square centimeter (kg/cm²) to 150 kg/cm².

4. A method according to any one of claims 1 to 3, **characterized in that** the metal substrate is a copper substrate.

5. A method according to claim 4, **characterized in that**, in the second thermocompression step, the thermocompression temperature lies in the range 500°C to 550°C, and the pressure applied for performing the thermocompression lies in the range 100 kg/cm² to 150 kg/cm².

## Patentansprüche

1. Verfahren zum Verbinden eines Diamantsubstrats mit wenigstens einem metallischen Substrat, **dadurch gekennzeichnet, dass**:
wenigstens eine Fläche des Diamantsubstrats mit einer Aluminiumfolie bedeckt wird;
das Diamantsubstrat und die Aluminiumfolie in einem Behälter mit gesteuerter Atmosphäre angeordnet werden und durch einen ersten Thermokompressionsschritt in Argon oder im Vakuum miteinander verbunden werden, wodurch ein Mehrschicht-Verbundsubstrat verwirklicht wird;
das Mehrschicht-Verbundsubstrat auf einem metallischen Substrat angeordnet wird, wobei die Aluminiumoberfläche mit dem metallischen Substrat in Kontakt ist; und
das Mehrschicht-Verbundsubstrat und das metallische Substrat durch einen zweiten Thermokompressionsschritt verbunden werden.

2. Verfahren nach Anspruch 1, **dadurch gekennzeichnet, dass** das Diamantsubstrat sandwichartig zwischen zwei Aluminiumfolien angeordnet wird.

3. Verfahren nach Anspruch 1 oder 2, **dadurch gekennzeichnet, dass** im ersten Thermokompressionsschritt die Temperatur der Thermokompression im Bereich von 550 °C bis 650 °C liegt und der für die Thermokompression ausgeübte Druck im Bereich von 100 bis 150 kg/cm² liegt.

4. Verfahren nach einem der Ansprüche 1 bis 3, **dadurch gekennzeichnet, dass** das metallische Substrat ein Kupfersubstrat ist.

5. Verfahren nach Anspruch 4, **dadurch gekennzeichnet, dass** die Temperatur der zweiten Thermokompression im Bereich von 500 °C bis 550 °C liegt und der für die zweite Thermokompression ausgeübte Druck im Bereich von 100 bis 150 kg/cm² liegt.
